# EUROPEAN PATENT SPECIFICATION

(11) **EP 3 846 601 B1**
(45) Date of publication and mention of the grant of the patent: **11.12.2024**
(21) Application number: 20205595.0
(22) Date of filing: 12.05.2010
(51) Int. Cl.: H05K 7/20, G06F 1/20

(54) **COOLED ELECTRONIC SYSTEM**
GEKÜHLTES ELEKTRONISCHES SYSTEM
SYSTÈME ÉLECTRONIQUE REFROIDI

(30) Priority: 12.05.2009 GB 0908156; 12.05.2009 US 17754809 P
(43) Date of publication of application: 07.07.2021
(62) Divisional of application: 10722744.9
(73) Proprietor: Iceotope Group Limited, Rotherham, South Yorkshire S60 5WG (GB)
(72) Inventor: CHESTER, Daniel, Rotherham, South Yorkshire S60 5WG (GB); HOPTON, Peter, Rotherham, South Yorkshire S60 5WG (GB); BENT, Jason, Rotherham, South Yorkshire S60 5WG (GB); DEAKIN, Keith, Rotherham, South Yorkshire S60 5WG (GB)
(74) Representative: Boult Wade Tennant LLP

(56) References cited:
- US-A1- 2008 173 427
- US-A1- 2008 266 726

## Description

### Technical Field of the Invention

This invention relates to a cooled electronic system. The invention is particularly applicable, for example, to computer processors and motherboards.

### Background to the Invention

Electronic components and in particular computer processors generate heat in operation, which can lead to overheating and consequent damage to the component and other parts of the system. It is therefore desirable to cool the component to transfer the heat away from the component and maintain the component temperature below the maximum operating temperature that is specified for correct and reliable operation of the component.

This issue especially concerns data processing or computer server centres, where a substantial number of computer processors are co-located and intended for reliable, continuous operation over a long time period. These centres may typically contain many server units, occupying multiple equipment racks and filling one or more rooms. Each server unit contains one or more server board. A single server board can dissipate many hundreds of watts of electrical power as heat. In existing systems, the energy required to transfer heat continuously so as to maintain correct operation can be of the same order of magnitude as the energy required to operate the servers.

The heat generated can be transferred to a final heat sink external to the building in which the processors are located, for example to the atmospheric air surrounding the building. Current implementations typically rely on air as the transfer medium at one or more stages between the processors and the final heat sink.

However, it is difficult to use air as a transfer medium for such a large quantity of heat, without imposing significant limitations on the building infrastructure. This is because the rate at which heat can be transferred increases with: increasing temperature difference (ΔT) between the heat source (such as the server boards, in particular the computer processors) and final heat sink; and decreasing thermal resistance of the path or paths thermally connecting the heat source and final heat sink.

Some known technologies for dealing with this difficulty are designed to control the environmental conditions of the location at which the processors are housed. Air handling techniques are currently often used, for example: vapour-compression refrigeration ("air conditioning") of the air that reduces the local air temperature to increase the local temperature difference; and air pressurisation (by the use of fans) to increase the air flow rate and thereby reduce the thermal resistance. Further heat exchange stages may be used to transfer heat extracted from the local air to a final heat sink, such as atmospheric air.

However, these approaches can be inefficient, as the use of air conditioning can require substantial amounts of electrical power to operate. These approaches can also make the location unpleasant for people, due to the local temperature and noise.

Furthermore, air flow rates and air temperatures may have to be limited, for example maintaining temperature above the "dew point" to prevent water vapour condensing out of air that may damage sensitive electronic components. For these reasons, servers are currently commonly distributed sparsely in order to reduce the heat density and improve local air flow, thereby reducing the thermal resistance.

Cooling the electronic components using a liquid that is brought into contact with the electronic components can be used to increase server density, reduce cooling costs or both.

An existing technique for cooling electronic components using a liquid is described in US-2007/109742 and GB-A-2432460. A computer processor board is housed inside an airtight container. A coolant liquid, preferably oil, is pumped through the container. The processor board is located at the bottom of the container and an evaporator coil is positioned at the top of the container, such that convection currents are produced in the coolant liquid. The coolant liquid is heated by the processor board and resultant vapour flows into a condenser. The container is positioned such that the circuit board inside lies in a horizontal plane to allow convection of heat from the components.

Using a condenser to provide refrigeration increases the complexity and cost of the system, and introduces further limitations on the system implementation.

WO-2006/133429 and US-2007/034360 describe an alternative known approach for cooling electronic components. The electronic component is sealed inside a container filled with a liquid and a thermally conductive plate is provided as part of the container in contact with the liquid. The thermally conductive plate conducts heat from the liquid to the outside of the container. Although this is designed for independent operation, the thermally conductive plate can be coupled to a further heat exchanger for additional cooling of the electronic component.

This alternative arrangement reduces the complexity of the system in comparison with approaches requiring pumped fluids inside the container. However, this does not significantly address the difficulty in reducing the thermal resistance between the heat source and the final heat sink. Even if the temperature difference is increased, the total thermal resistance will still be significant.

US-2008/173427 describes a sealed chamber that is filled with a first cooling fluid. A second cooling fluid that does not contact the first cooling fluid is circulated so as to remove heat from the first cooling fluid and is transported to an external heat removal system. US-2008/266726 concerns a server and a sensor that detects when a first fluid line to the server fails so a second fluid line to the server is activated.

### Summary of the Invention

Against this background, the present invention provides a cooled electronic system in line with claim 1. The dependent claims define preferred embodiments.

### Brief Description of the Drawings

The invention may be put into practice in various ways, one of which will now be described by way of example only and with reference to the accompanying drawings in which:
Figure 1 shows a simplified front view of an equipment rack containing multiple cooling units, each cooling unit comprising two sealable modules according to the invention;
Figure 2 is a simplified cross-sectional side view of the equipment rack shown in Figure 1;
Figure 3 illustrates a cooling unit, as shown in Figure 1, fitted with a cover;
Figure 4 depicts a cooling unit with its cover removed, showing two sealable modules according to the invention;
Figure 5 is a cross-sectional exploded view of a sealable module comprising a heat generating electronic component according to an embodiment of the invention;
Figure 6 is a cross-sectional view of the upper part of the sealable module of Figure 5;
Figure 7 shows the sealable module face of an embodiment of a cold plate, for use with the sealable module of Figure 5;
Figure 7A shows an embodiment of the opposite face of a cold plate from that shown in Figure 7, showing liquid flow channels for a second cooling liquid, for use with the sealable module of Figure 5;
Figure 7B shows an alternative embodiment of the face of the cold plate 60 shown in Figure 7A;
Figure 8 is a schematic view of a three-stage cooling system comprising a single cooling unit according to the invention;
Figure 9 is a block diagram showing a three-stage cooling system with multiple cooling units according to the invention;
Figure 10 shows a monitoring and control system for use with the three-stage cooling system of Figure 9;
Figure 11A shows a first side view of a second embodiment of a sealable module according to the present invention;
Figure 11B shows a second side view of the embodiment shown in Figure 11A; and
Figure 11C shows a more detailed view of the embodiment shown in Figure 11A and Figure 11B.

### Specific Description of a Preferred Embodiment

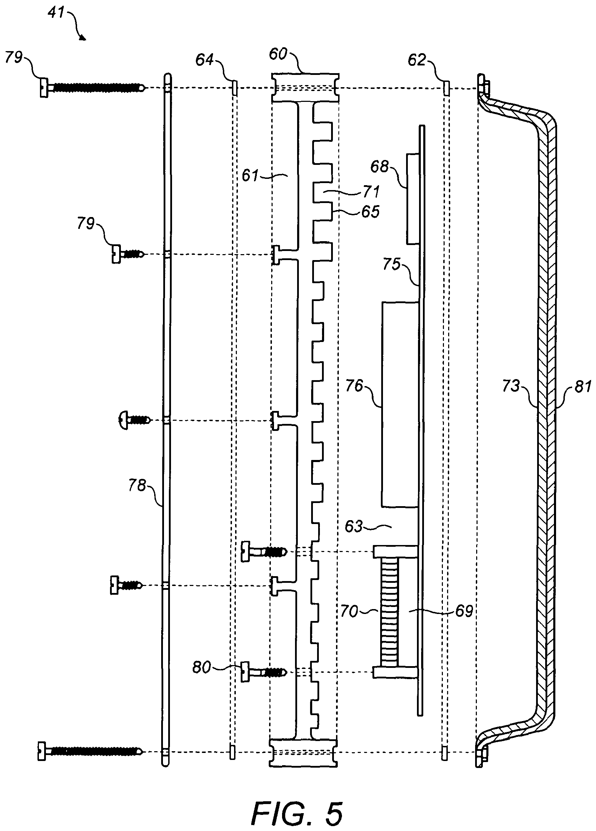

Referring first to Figure 5, there is shown a cross-sectional exploded view of a sealable module 41 comprising a heat generating electronic component 69 according to an embodiment of the invention. The sealable module comprises: a housing 81; a finned conduction surface 71 forming part of a cold plate 60; a container volume, defined after assembly of the components by the housing 81 and conduction surface 71 and filled with a first cooling liquid (not shown); liquid flow channels 61 adjacent the conduction surface 71; small electronic component 68; large electronic component 69; and memory module 76.

The sealable module further comprises: an electronic circuit board 75; mounting pillars 63 for the electronic circuit board 75; a component heat sink 70 attached to the large electronic component 69; screws 80 to attach the mounting pillars 63 to the conduction surface 71; a cover plate 78 for the side of the cold plate opposite to the fins on the conduction surface; insulation 73 for the housing 81; first sealing gasket 62; second sealing gasket 64; screws 79 to hold the components of the cold plate assembly together; and pin-fin projections 65 on the conduction surface 71. The insulation 73 can also serve as a protective membrane between the housing 81 and the circuit board 75.

The cold plate 60 is fabricated with two faces, each with a separate function. Conduction surface 71 is a pin-finned plate, forming one face of the cold plate. A housing 81 is attached to the pin - finned plate 71, in such a way as to provide an internal space for an electronic circuit board 75, the pins of the cold plate and a first cooling liquid (not shown). A gasket 62 ensures that the assembled capsule is substantially sealed against liquid loss or ingress of air. The pin-finned plate is effectively the lid of the assembled capsule.

The electronic circuit board 75 carrying components to be cooled is attached to the cold plate 60 by mounting pillars 63, so as to suspend the board from the cold plate 60, allowing accurate alignment of the fins of the cold plate with components on the board, prior to attaching the housing 81.

Alternatively, the board may be attached to housing 81 by mounting bosses extending from the housing 81 or equivalent means.

The fins 65 of the pin-finned conduction surface 71 normally face the component side of the circuit board 75. In some cases, components of significant size may be present on both sides of the board. The housing may then be contoured around the components on the side of the board opposite the pin-finned conduction surface 71, in order to improve flow of the cooling liquid and reduce the amount of cooling liquid needed.

In the embodiment shown in Figure 5, the cold plate is fabricated in a single part, with two separately formed faces. Alternatively, the plate may be manufactured in two parts: a pin-finned plate whose opposite face is flat; and a plate with channels 61 for liquid flow, again with a flat opposite face; the two flat faces being joined on assembly. The cold plate assembly 60 has a surface opposite to the pin-finned conduction surface into which channels whose cross section is shown at 61 are manufactured.

The component side of the electronic circuit board 75 faces the fins 65 on the conduction surface 71. A small gap between the ends of the fins and the components is provided. The fins have an elongated cross-section and the height of the fins varies, so as to maintain a small gap between the variously sized components on the electronics circuit board and the tops of the fins. The faces of the electronic components 68 and 69 and the edge of the memory module 76 project by different amounts from the surface of the board. Small component 68 has a relatively low profile and large component 69 has a much deeper profile and the corresponding fins 65 have accordingly different heights. The height of the pin-fins and the gap between components on the circuit board 75 and the top of the pin-fins are arranged to be as small as possible, consistent with the requirement for efficient cooling. This arrangement reduces the total quantity of cooling liquid needed in the capsule and improves packing density of cooling units.

When the system is in operation, heat generated by the components 68, 69 and memory module 76 on the circuit board is transferred to the cooling liquid (not shown), initially by local conduction and then, as the heated liquid expands and becomes buoyant, by convection. The convecting liquid quickly comes into contact with the fins 65 and other surfaces of the conduction surface 71.

Heat from the fins 65 of the conduction surface 71 is conducted to the circulating second liquid that flows via channels 61, so as to cool the conduction surface 71 and thus cooling liquid.

Components on circuit board 75 that generate the largest amount of heat are typically microprocessors. In this case, cooling efficiency for such components may be improved by additionally fitting a finned component heat sink 70, in direct physical and thermal contact with the component, whose fins may interleave with the array of fins on the cold plate. The fins of the component heat sink may be at least partially in physical contact with the pin-fins of the cold plate. Gaps remain through which the first cooling liquid can flow.

An additional insulating layer 73 is provided, preferably on the inside of the housing 81 of the sealable module 41. Additional insulation may also be added to the exterior of the cold plate cover 78 and to the edges of the cold plate 60. The insulation reduces local heat loss into the atmosphere, which can be significant in large installations with many electronic circuit boards, causing room temperature to rise to undesirable levels.

Electronic circuit board 75 may carry major components only on one side or the other side may carry only small components that generate low amounts of heat in operation. The operation of the sealable module 41 may then be improved by excluding liquid flow adjacent to the non-component side of the circuit board 75. The insulation 73 may then act as a flexible protective membrane between the circuit board 75 and the housing 81, that can accommodate to the shape of the small components that may be mounted on this side of the board. Alternatively, a separate protective membrane (not shown) could be provided between the housing 81 and the electronic circuit board 75. Convective flow of the cooling liquid is then concentrated in the space between the main component side of the circuit board 75 and the conduction surface 71.

Application of the invention is not limited to computing systems. However, since computing systems generate significant heat, they can benefit from improved cooling. In such systems, one or more microprocessors and several other digital and analogue devices such as memory chips (RAM, ROM, PROM, EEPROM and similar devices), specialised integrated circuits (ASICs) and a range of associated active and passive components are typically mounted on a circuit board, whose function is to act as a major part of a computing system. Although electronic components can be mounted on both sides of the circuit board, it is more usual to mount at least the bulky components on one side only. Other devices are connected to the circuit board by cables, optical means or wireless transmission, the whole forming a computer, computer system or server.

Heat is generated by the various components but, typically, the microprocessor is the highest heat-generating component. An optimally designed cooling system removes sufficient heat from each component to keep it within its designed operating temperature range but no more than that. Devices that generate less heat need less cooling than those that generate larger amounts. Cooling below a level necessary for satisfactory operation will normally consume unnecessary additional energy and is therefore less than optimally efficient.

Moreover, packing density of components on computer boards is determined partly by the traditional size of computer housings and the assumption that air-cooling may be employed. In large systems, especially server centres, increasing the packing density of components to reduce overall space occupied is desirable. At the same time, heat generated will be concentrated in a smaller space and needs more effective means of removal. Improving heat removal may enable component packing density to be increased and, more particularly, allow processing power per unit volume to increase.

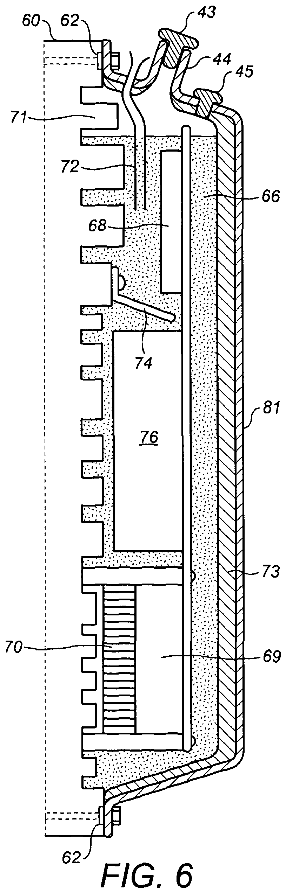

Referring now to Figure 6, there is shown a cross-sectional view of the upper part of the sealable module 41 of Figure 5. Where the same features are shown, identical reference numerals are used. The depth of the module is exaggerated to clarify details of some features that would otherwise be difficult to illustrate. Figure 6 additionally shows: first cooling liquid 66; a filling inlet 44; seal 43; a pressure relief device 45; fastener82 for receiving assembly screw 79; sealing gasket 62; baffle plate 74; and capacitive rods 72. The filling inlet 44 is intended for receiving the first cooling liquid 66 and has a seal 43 to prevent liquid loss once the sealable module 41 is filled. A pressure relief device 45 allows escape of liquid under extreme conditions, outside a normal range of: temperature; pressure; or both.

Normally, larger components that generate the highest amount of heat are located towards the lower part of the module 41. In some circumstances, the heated liquid 66 may rise in a narrow convection plume that could overheat components located higher in the module. Baffle plate 74 may then be fitted to deflect the hot plume of liquid away from the components in the upper part of the module and aid mixing with cooler liquid for re-circulation within the module. Similarly, where two or more processors that generate large amounts of heat are fitted to circuit board 75, it is possible that one processor is above the other and receives heated liquid from the lower mounted processor. A baffle plate 74 or a similar or equivalent means of passively deflecting hot liquid may then be fitted in the lower part of the module.

Typically, cooling liquid 66 is a volatile substance. Small leaks from the module may be difficult to detect, since the liquid may evaporate before being observed. Capacitive rods 72 may then be fitted in the upper part of the module 41, normally immersed in liquid 66 and connected to an external detector (not shown) that measures the capacitance. In the event that the liquid leaks from the module, the level of liquid 66 will drop and the capacitance will alter. If the capacitance alters appreciably, an alarm can thus be generated, indicating excessive loss of liquid from the module. The capacitive rods 72, the connections thereto and a detection circuit may alternatively be built in to a customised electronic circuit board, thus simplifying assembly of the complete capsule and removing the possibility of leakage of liquid from the entry point of the capacitive rods 72 into the housing 81.

An alternative means of monitoring the liquid level is a small transparent window (not shown) that may also be fitted to the upper part of housing 81. This window allows direct observation of the level of liquid 66 within the module.

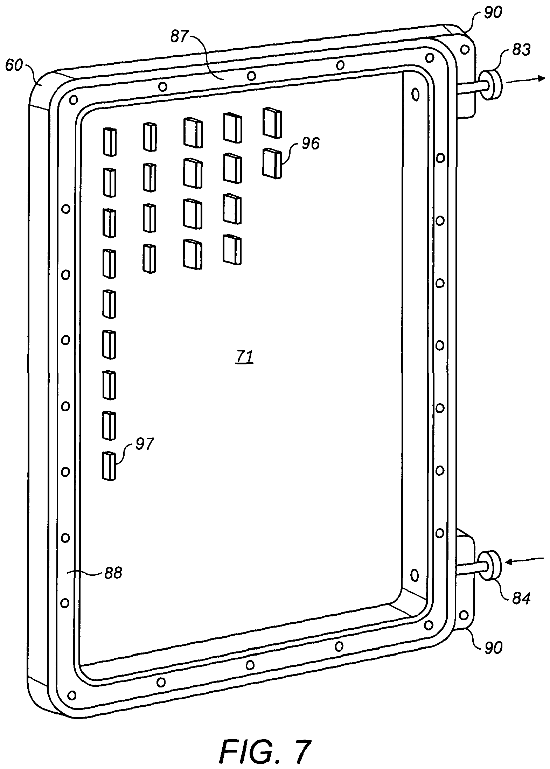

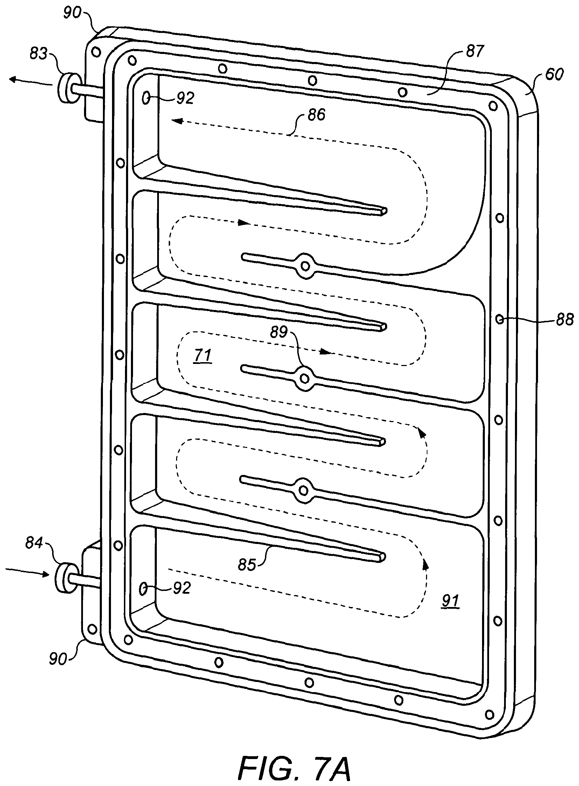

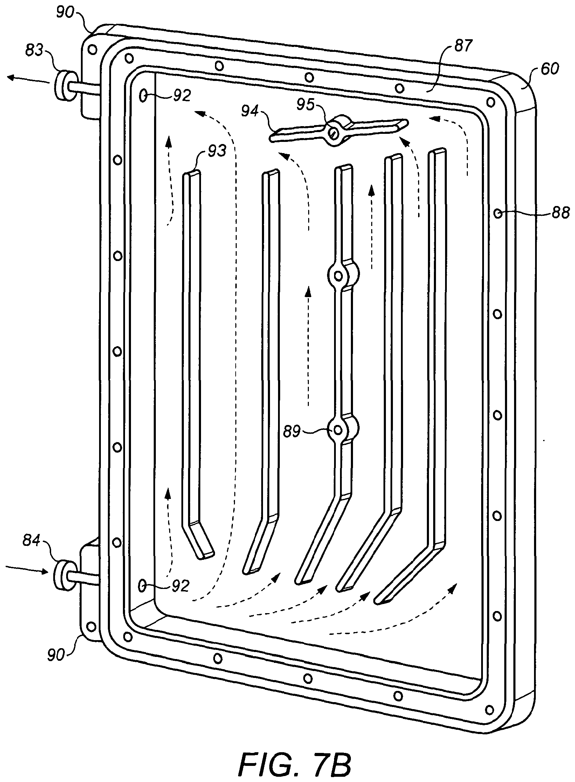

Referring now to Figure 7, there is shown one face of an embodiment of a cold plate 60, for use with the sealable module 41 of Figure 5. This face provides a pin-finned plate that attaches to housing 81 as shown in Figure 5 to form a sealable first stage cooling module. Figure 7A shows the opposite face of the embodiment of the cold plate.

The face of cold place 60 shown in Figure 7 comprises: conduction surface 71; first pin-fin 96; second pin-fin 97; a channel 87 for a sealing gasket; and holes 88 for assembly screws to attach the housing 81 of Figure 5. The pin-fins 96 and 97 form projections from the conduction surface 71.

An inlet 84 and outlet 83 for the second cooling liquid are visible in Figure 7 but connect to the other side of the cold plate. Mounting lugs 90 for the complete module also support the liquid inlet and outlet pipes 83, 84.
The pin-fins 96 are of greater height than pin - fins 97. The illustrated pin-fins are examples and the actual layout and size of pin - fins may vary according to the shape and heat - generating characteristics of the components to be cooled.

Turning now to Figure 7A, there is shown an embodiment of the opposite face of the cold plate 60 to that illustrated in Figure 7, for use with the sealable module 41 of Figure 5. Flow directing fingers 85, 89 create channels 91 in the cold plate 60 that form a continuous winding pattern within the boundary of the cold plate 60 and join via holes 92 to tubes that emerge as inlet connector 84 and outlet connector 83 for the second cooling liquid.

The flat part of this side of the cold plate 60 is the opposite side of conduction surfaces 71 shown in Figure 7. Cover 78 of figure 5 is attached to the cold plate by screws that align with holes 88 and is sealed by a gasket that fits in channel 87, so as to enclose the channels 91, thus creating a winding channel arrangement within the assembly. Since the assembled arrangement of channels requires no maintenance, an improved assembly may be constructed by welding the cover 78 directly to the cold plate 60 base part. Adhesive or other techniques for fixing the cover permanently can alternatively be used. Gasket 64 and assembly screws are then not required and the potential for leakage of the second cooling liquid is reduced.

Alternatively, the single winding channel arrangement may be branched to form two or more channels, with common input and output connections for the second cooling liquid. The two or more channels may be of similar or different dimensions, and may be winding or straight, so as to provide a different flow rate of second cooling liquid over different parts of the cold plate.

Turning to Figure 7B, there is shown an alternative embodiment of the face of the cold plate 60 shown in Figure 7A. This illustrates one possible arrangement with several channels, aligned generally in a vertical orientation. The channels are bounded by flow directing fingers 93. The flow of liquid entering via inlet 84 is divided amongst the channels; the flow rate in each channel being dependent on the width of the channel, the shape of the entrance to the channel and the location of the liquid entry hole 92.

Thus, it is possible to arrange the assembly so as to provide similar or different liquid flow rates over different areas and thus different heat transfer rates from different parts of the plate. Electronic components adjacent to the conduction surface on the other side of plate 60 from the channels may generate different amounts of heat. With higher levels of heat production, this may advantageously be made to correspond with the areas with higher rates of heat transfer.

A degree of adjustment may, optionally, be included in the assembly. One or more adjustable baffle plates 94 attached by locking screws 95 may be positioned so as to direct the flow of liquid more towards or away from one of the channels. The baffle plate may be adjusted by slackening screw 95, rotating the baffle plate to a new position and then re-tightening the screw. In this example, the adjustment is made before the cover is attached, although it would be readily possible to add means of adjusting the baffle plate from the exterior of the assembled unit.

Mounting lugs 90 for the complete assembly also support the inlet connector 84 and outlet connector 83.

The material used for the cold plate 60 and conduction surface 71 is chosen to be a good conductor of heat, typically a metal. For ease of fabrication and lower cost in quantity production, a plastic material could be employed with lower but still adequate heat conduction properties. The channels 91 formed within the cold plate 60 are used to carry a second cooling liquid that circulates through the cold plate and then outside to carry heat away to further cooling stages of the system.

The sealable modules 41 provide a first stage of cooling and form part of cooling units, each cooling unit carrying one or more modules. At least one and typically many first-stage cooling units are deployed in a system. The cooling units may be fitted into any convenient housing but, where large numbers are used in a system, conventional equipment racks would normally be used.

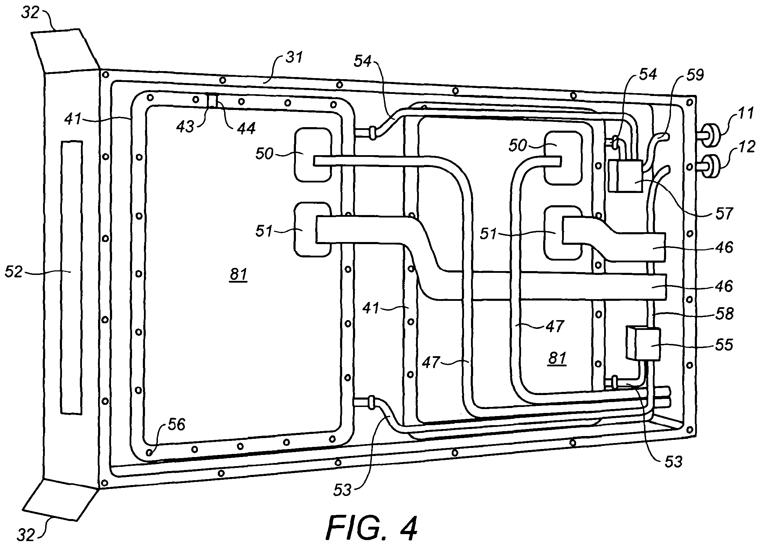

In Figure 4, there is shown a cooling unit with its cover removed, showing two sealable modules. Where the same features are shown in Figure 4 as in Figures 6 and 7, identical reference numerals are used. In addition is shown: frame 31; locking tabs 32; data transfer cable 46; power cable 47; first seal for cable entry 50; second seal for cable entry 51; and test and monitoring panel 52.

Essentially, Figure 4 shows the sealable part of each cooling module 41, the remaining part being on the opposite side of the module, separated by the internal cold plate and conduction surface of Figure 5. The cooling unit comprises a frame 31, which supports cooling modules 41 and various liquid and electrical interconnections. The front panel of the frame 31 carries a test and monitoring panel 52 and locking tabs 32, which can rotate about a hinge so as to lock the unit in place in an equipment rack.

Two sealed modules 41 are shown. The housing 81 for each sealable module 41 is made of plastic or equivalent material, chosen to be an electrical insulator, and to have heat insulating properties, as well as not reacting with the cooling liquid used in the module. Housing 81 is held down by fasteners 56. Cables 46, 47, carrying electrical power and supporting bi-directional data transmission enter the capsule via entry points 50 and 51, sealed to prevent the escape of liquid or the ingress of air. Cables 46, 47 terminate in respective connectors (not shown) at the rear of the cooling unit.

The cold plate side of each module (not shown in Figure 4) is cooled by a circulating second liquid. Each of the two sealable modules 41 is connected via an inlet pipe 53 for the second cooling liquid, to a liquid flow splitter 55. The liquid flow splitter 55 has two outputs and a common input, connected by a further pipe 58. This splits the flow of second cooling liquid between modules 41 and the common input is connected by a further pipe 58 to liquid input connector 12 on the rear panel of the cooling unit. Similarly, a liquid outlet pipe 54 from each of the two sealable modules carries liquid to a flow- combining unit 57, the common output of which is connected by a further pipe 59 to liquid output connector 11 on the rear panel of the cooling unit.

The assembled sealable module 41 is partly or wholly filled with a first cooling liquid 66 via the filling inlet 44 and then sealed with sealing device 43. The filling procedure may take place during factory assembly or during field installation of cooling modules.

During filling, the sealable module 41 is partly filled with liquid, the remaining space being occupied by a mixture of its vapour and some residual air. One method of achieving this is by heating the liquid and the module to a filling temperature (T_{fill}), selected to be well above ambient temperature and approximately the same as the maximum operating temperature of the system (Tₘₐₓ). The maximum storage temperature of the electronic components is typically much higher than maximum operating temperature, so that T_{fill} can either be below, equal to or above Tₘₐₓ, the highest envisaged operating temperature of the system.

Liquid is then added to displace most of the air within the sealable module 41, such that the level of liquid is sufficient substantially to immerse all the components to be cooled. The sealable module 41 is then sealed with sealing device 43 to prevent liquid escape and ingress of further air. The sealable module 41 is then allowed to cool to room temperature. The liquid contracts and leaves a space, occupied by liquid vapour and air mixture. The filling procedure may take place in two or more steps, allowing time for liquid that has been added to the sealable module 41 in one step to cool partly before adding more.

At ambient temperature, the vapour and air in the filled and sealed module is thus below atmospheric pressure. This can rise during operation so as be equal to or moderately higher than external atmospheric pressure. A module filled at ambient temperature and then immediately sealed would, during operation and heating to Tₘₐₓ, be subjected to much higher and potentially damaging internal pressure than one filled by the method described.

The method may, if desired, be extended to exclude all air from the liquid by filling the module completely at T_{fill} and choosing T_{fill} to be higher than Tₘₐₓ, so that, on cooling, the remaining space above the liquid is filled only with vapour from the liquid at a low pressure below atmospheric. Heating the liquid has the additional benefit of driving out some or most of the dissolved gaseous contaminants that may be present in the untreated liquid.

A further alternative method of filling is to add liquid via filling inlet 44 to the module 41 when both are at ambient temperature, so as to fill to a pre-determined level, sufficient to immerse substantially the electronic components to be cooled. Before sealing with seal 43, the module is then connected to its power supplies and the electronic components set into operation in such a way as to elevate the liquid temperature to or close to Tₘₐₓ. The module is then sealed, disconnected from its power supplies and left to cool.

Yet another method of filling is under vacuum, such that liquid can be added to the module at ambient temperature, whilst all or most air is excluded. One way of achieving this is to fit a valve and a means of connecting a tube for air to be pumped out and liquid to enter to sealing device 43. The tube opens the valve when connected but releases the valve when removed and allows it to seal the module automatically. The tube has a tee connection, one arm of which is connected to a vacuum pump via a further closable valve. The other arm of the tee connection connects via a flexible tube to a container filled with a pre-determined quantity of the filling liquid. Initially, the container is held at a level where the liquid is below the level of the filling inlet. The ends of the tube make an airtight seal with the module and container respectively. The valve to the vacuum pump is opened and most of the air is pumped out of the module and liquid container. The valve to the vacuum pump is then closed and the container is raised so as to be above the level of the filling inlet. Liquid then flows into the module so as to fill the available space to a pre-determined level and immerse the components to be cooled. Finally, the tube with tee connection is withdrawn from the module and the filling inlet valve seals automatically against ingress of air or loss of liquid. The module has thus been filled with liquid to a predetermined level, leaving a vapour or air space at low pressure, below atmospheric.

An alternative method that is also useful in field filling is to fill with a cool or warm liquid, since there is increased danger of spilling hot liquid. In this case, an air gap is always left above the liquid to allow for expansion. Liquid may be factory prepared to remove dissolved gases and is then stored in sealed containers. The interior space of the sealable module 41 is filled with dry air and the sealing device fitted. When filling the sealable module 41 with liquid, the sealing device 43 is removed, a specified amount liquid is poured into the sealable module 41 via the filling inlet 44 and the sealing device 43 is then immediately refitted. The specified amount of liquid added is sufficient for effective cooling but leaves a remaining space filled with air for expansion of the liquid at temperatures up to Tₘₐₓ, the highest envisaged operating temperature of the system.

At temperatures below the lowest envisaged room temperature, the liquid may contract further and the electronic circuit board 75 may no longer be fully immersed in liquid. This is envisaged to occur when the module is inactive, in storage or being transported, for example by air, when low external pressure and temperature conditions may occur. The seal 62 between the housing and cold plate is intended to withstand temperature and pressure variations between the limits envisaged for inactivity, storage and transportation and the conditions at Tₘₐₓ.

Above Tₘₐₓ, the system would be outside its design temperature range. Although higher temperatures are very unlikely, the pressure relief valve device 45 allows escape of liquid that has exceeded Tₘₐₓ, the temperature at which the liquid fills or is close to filling the available space inside the module. The pressure relief device may be combined with the seal 43 for the filling inlet 44.

The first cooling liquid 66 is chosen on the basis of a number of desirable characteristics. It should not significantly affect the performance of the electronic circuit board 75 or the transmission of information between the circuit board 75 and other external devices. It should not be corrosive to any component of the cooling module, remain liquid at all operating, storage and transportation temperatures, have sufficiently good specific heat capacity, in order to carry heat away from the electronic components as efficiently as possible, have a high enough coefficient of expansion and low enough viscosity to aid rapid convection, be low-cost, be safe to use and be non-hazardous in case of leakage.

One example of a suitable first cooling liquid 66 is a hydrofluoroether chemical. This has all the desirable characteristics, including a high coefficient of expansion and sufficiently high specific heat capacity to provide high mass-flow rate and rapid convection when heated, thus carrying heat quickly away from the hot components.

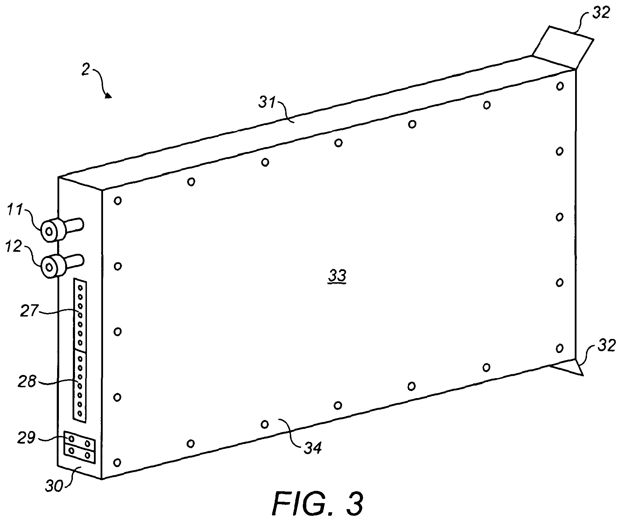

In Figure 3, there is illustrated the cooling unit of Figure 4, on which frame 31 is fitted with a cover 33 to form an assembled cooling unit 2. Cooling unit 2 further comprises: first data connector 27; second data connector 28; first power connector 29; second power connector 30; and front panel locking tabs 32.

When housed in a standard equipment rack, each cold plate 60, within its respective sealable module 41, is commonly in the vertical plane. Each cold plate 60 carries liquid from inlet 12 also associated with a pair of sealable modules 41 inside the cooling unit 2.

The cover 33 is held in place by screws 34 or equivalent fixings, protects the sealable modules 41 and other internal parts of the cooling unit 2 and gives additional EMC protection. The cover additionally completes an external rectangular box shape that is convenient for sliding into and out of a shelf in a rack for installation, repair or replacement.

Electrical connections are also made at the rear of the module, for power 29,30 and data transfer 27, 28. Standard connectors may be employed to allow connection and disconnection of the module for installation and removal.

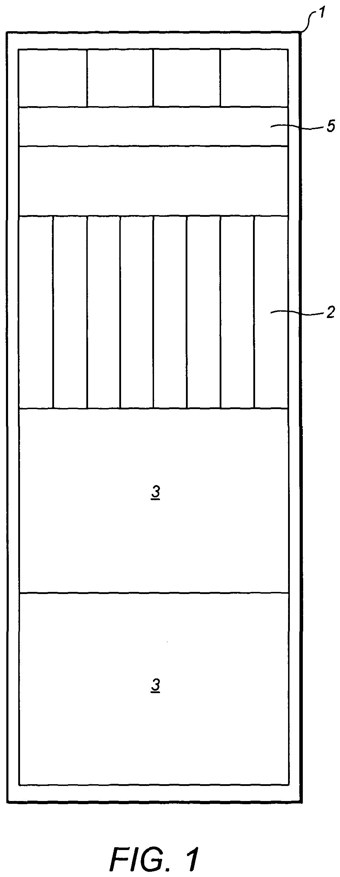

Reference is now made to Figure 1, in which there is shown a simplified front view of an equipment rack containing multiple cooling units. Equipment rack 1 comprises: cooling unit 2; additional equipment shelves 3; AC power unit 4, which is commonly air-cooled; and cold plate 5 to provide additional cooling for the AC power unit 4. The AC power unit 4 may alternatively be cooled by immersion in a liquid or by thermal coupling to a cold plate. Rack 1 houses a number of AC power units and cooling modules 2 and has expansion room for further modules in additional equipment shelves 3. The modules are removable for replacement or repair. Figure 1 shows a typical packing density of modules. Only one shelf 3 of the rack 1 is filled with cooling units 2. The others could be similarly filled with cooling units 2. Cooling units 2 are inserted from the front of the rack.

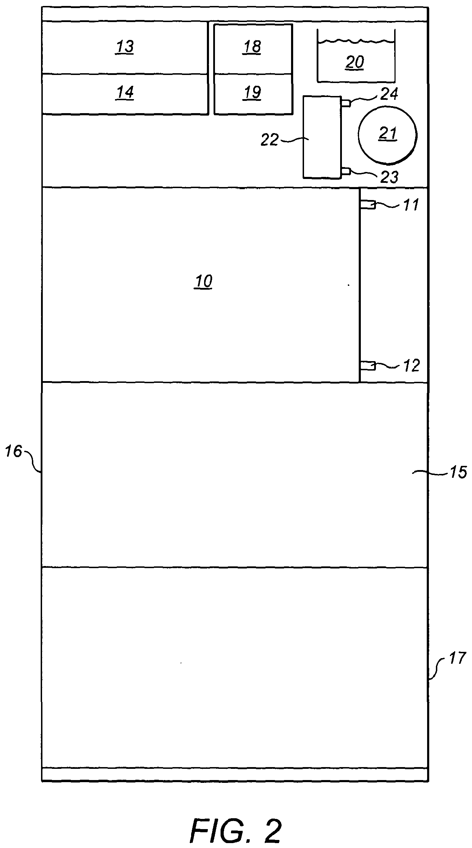

In Figure 2, there is shown a simplified cross-sectional side view of the equipment rack shown in Figure 1. The front 16, side 15 and rear 17 of the rack 1 are shown.

The equipment rack 1 additionally houses towards the rear: a first plenum chamber 18 (a pressure equalisation device); a second plenum chamber 19; a pump 21; a header tank 20; a heat exchanger 22; a first liquid connector 23; and a second liquid connector 24.

Liquid connections 11 and 12 are also shown on the cooling unit 2. These interconnect with a system of pipes in a second liquid cooling stage of the system, which will be described further below. These are normally at the rear 17 of the rack, although in circumstances where rear access is not convenient, they could be at the front 16 of the rack. In this example, the cooling unit 2 has one liquid inlet and one liquid outlet, serving two independently cooled sealable modules 41 within each cooling unit 2.

The first plenum chamber 18 collects cooling liquid from a number of cooling units 2. The second plenum chamber 19 distributes cooling liquid to a number of cooling units 2. The pump 21 assists circulation of the cooling liquid via the plenum chambers 18 and 19. The header tank 20 is for the cooling liquid circulated by the pump 21. The heat exchanger 22 transfers heat from liquid in the second liquid cooling stage to liquid in a third liquid cooling stage. Liquid connectors 23 and 24 carry liquid in the third cooling stage to and from the heat exchanger to equipment outside the rack.

Thus, a first stage of cooling electronic components has now been described. The first stage provides a low-cost cooling module, using non-forced cooling (in this case using conduction and convection through a cooling liquid to transport heat) and the ability by some means to detach and replace any faulty module with a module that is working correctly. There may be any number from one to a large number of such modules in a system.

In the first stage, at least one sealable module 41 is used. Each sealable module 41 houses one or more electronic circuit boards, power supply units, DC to DC power converters or disk drives to be cooled. Heat is removed from the heat-generating electronic components to the first cooling liquid 66 contained within the sealable module and is then transmitted from the first cooling liquid 66 via the conduction surface 71 to a second cooling liquid flowing through the cold plate base 22.

The second cooling liquid is used in a second stage of cooling and a means of circulating the cooling liquid is provided so as to carry heat away from the first stage. A third stage of cooling can also be used to avoid the use of liquids flowing through cooling units under high pressure.

Further intermediate stages of heat transfer also use liquid to carry heat to a final heat exchanger. Further cooling stages desirably include cooling liquid flow-rate management for the different stages of the system, and pressure management, in order to avoid high cooling liquid pressure in sealable modules, whilst allowing liquid to be pumped effectively to a final heat sink. The system thereby uses multiple stages of heat transfer using liquids in all stages up to the final heat exchanger.

Sufficient heat is removed to keep components within their specified temperature range but not significantly more than that. Additional heat transfer and lower temperatures that allow alternative operating modes such as "over-clocking" of processors are possible using the system but not necessary in normal operation, since additional energy is consumed in achieving these lower operating temperatures and the alternative modes of operation are not in common use in large scale systems.

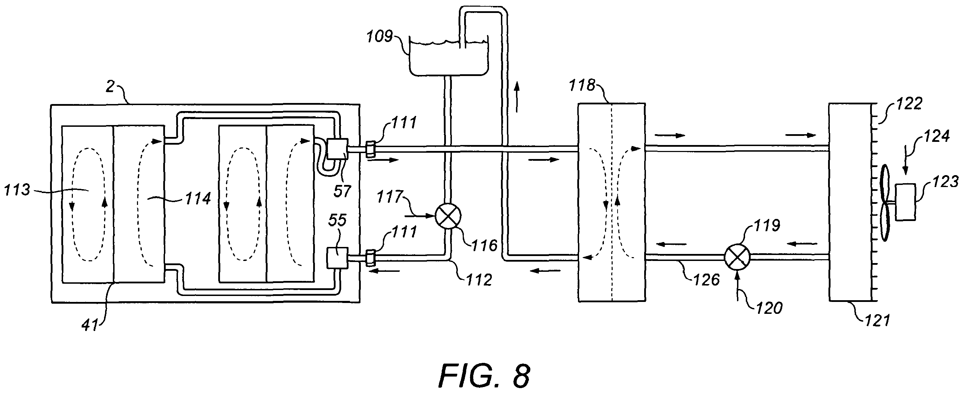

Referring now to Figure 8, there is shown a schematic view of a three-stage cooling system comprising a single cooling unit 2. The cooling unit 2 houses two sealable modules 41, each of which has a first cooling stage 113 using liquid convection and a second cooling stage 114 in which second cooling liquid is circulated outside the cooling unit 2. Liquid flow to the two sealable modules 41 is provided via flow splitter 55 and liquid flow from the modules 41 is combined in flow combiner 57. The system further comprises: quick release connectors 111; pipes for second cooling liquid 112; first pump 116; pump control 117; header tank 109; heat exchanger 118; second pump 119; pump control 120; pipes for third cooling liquid 126; and heat exchanger 121.

Pipes 112 are joined via quick release devices 111 that also contain a means of isolating the second cooling liquid in the cooling module and pipes. When the cooling unit 2 is connected, the liquid can flow normally but when the cooling unit 2 is disconnected, these close off the liquid flow and prevent liquid loss from the module or pipes.

The second cooling liquid circulates through the cold plate (not shown) of the sealable module 41 to a heat transfer device 118 and is then returned to the cold plate via a header tank 109, which regulates the liquid pressure in the second cooling stage so as to be only moderately higher than atmospheric pressure, and a first pump 116 supplied with electrical power from pump control 117, which can be varied to alter the pumping rate according to the amount of heat generated in sealable modules 41 either locally or by means of a control signal from an external device. In the illustrated embodiment, the two cooling circuits within the cooling unit are connected in parallel via splitter 55 and combiner 57. The flow-rate in each of the parallel circuits can be separately pre-adjusted within the splitter 55 and/or combiner 57 to take account of different amounts of heat generated in each arm of the cooling system. The direction of liquid flow is shown by arrows.

The heat transfer device 118 has two liquid flow circuits. The heated second cooling liquid from the cooling module circulates through a first circuit. Cool liquid in the third stage circulates through a second circuit. Heat is transferred from liquid in the first circuit via a heat-conducting interface to liquid in the second circuit, which then flows away through pipes 126 to a final heat exchanger 121. The direction of liquid flow is again shown by arrows.

Heat exchanger 121 comprises: heat exchanger cooling plate 122; fan 123; and power supply 124. This is a conventional device, commonly referred to as a "dry cooler", that may use atmospheric air as the final heat sink medium, this being blown by fan 123 driven by electrical power 124 across a finned cooling plate or equivalent means of heat transfer to cool the circulating third cooling liquid. The cooled liquid is then returned via a pump 119 driven by electrical power 120 to the heat transfer device 118.

The three stages of liquid heat transfer are desirable in situations where the final heat exchanger is located some distance from the equipment to be cooled, for example on the roof of a building. In this case, the pressure difference between liquid circulating through the final heat exchanger 121 and the intermediate heat transfer device 118 may be large. The second stage of heat transfer can use a liquid with a much lower pressure, so that the potential for liquid to leak within the first stage cooling modules and damage the electronic circuit boards is greatly reduced.

Since the second and third cooling liquids are not in contact with the electronic circuit board 75 (not shown), their characteristics are less constrained than those of the first cooling liquid 66. Water, which has the highest specific heat capacity of any common liquid and has very low cost, can be used effectively. An additive to reduce corrosion and bacterial contamination may optionally be used.

The probability of leakage of the second cooling liquid is greatly reduced by limiting the pressure in the second cooling stage. Header tank 109 provides regulation of the pressure in this stage. If any leakage should occur, the fluid may be distinguished from liquid used in the first cooling stage by addition of a small amount of dye. Since the second cooling liquid can be water, a range of low-cost non-toxic dyes is available for this purpose.

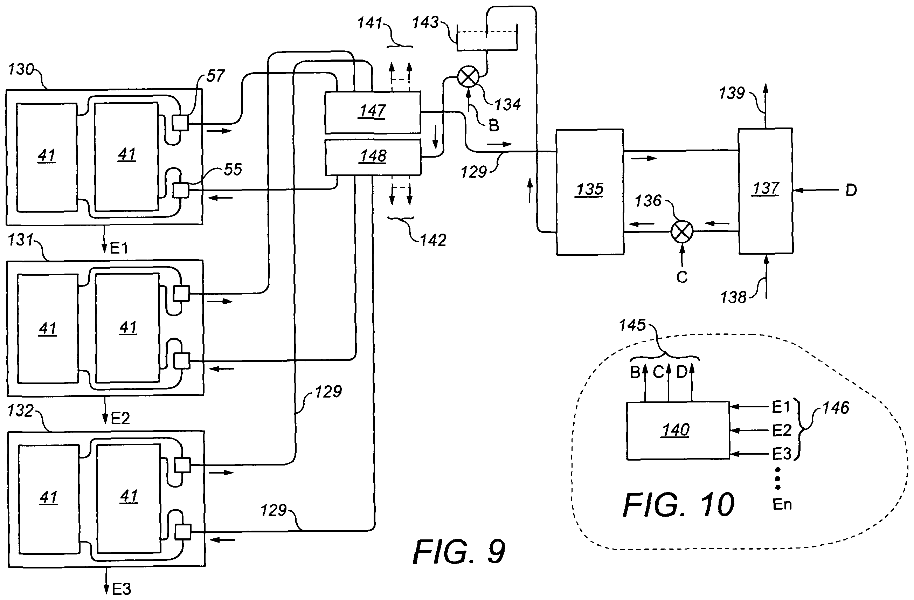

Referring now to Figure 9, there is shown a block diagram showing a larger scale three-stage cooling system with multiple cooling units according to the invention. Three cooling units, each with two sealable modules according to the invention are shown but, typically, many more units can be accommodated in a system. This example of a larger scale cooling system, comprises: cooling units 130, 131, 132; pipes 129; plenum chamber 147 to combine liquid flow from cooling units; plenum chamber 148 to distribute liquid flow to cooling units; pump 134 for second cooling liquid; header tank 143; heat exchanger 135; pump 136 for third cooling liquid; final heat exchanger 137; final coolant entry 138 to final heat exchanger; and final coolant exit 139 from final heat exchanger.

A number of cooling units 130, 131, 132 are mounted in a housing or rack with an arrangement such as that shown in Figure 1. The liquid flow through the cooling units 130, 131 and 132 is connected in parallel fashion via plenum chambers 147 and 148. Each of the cooling units 130, 131 and 132 typically contains two or more sealable modules 41 and can be disconnected and removed from the rack separately, using quick release connectors such as those shown in Figure 8, for replacement or repair. The number of cooling units can be extended, as indicated schematically via the additional inputs 141 and outputs 142 of the plenum chambers to a large number.

Plenum chambers 147 and 148 are advantageously insulated to improve efficiency by reducing local heat loss and reducing transfer of heat between the input plenum and the output plenum. A further improvement is to locate plenum units directly in line with the connectors of cooling units 130, 131, 132, thus simplifying pipe arrangements and reducing the total number of liquid connectors in a system.

The second cooling liquid flow is divided amongst the cooling modules by a parallel arrangement of pipes 129 from plenum chamber 148, typically with one set of pipes per cooling unit, each serving two sealable modules 41 mounted therein. The flow rate to each sealable module 41 can be varied by use of restrictors and baffle plates in the plenum chamber 154

By adjusting the flow rate to each cooling unit independently, a more efficient system is produced with a more uniform temperature of the heated second cooling liquid from the various cooling units.

Heated liquid from the cooling units is returned via pipes 129 to plenum chamber 147, where it is combined and delivered via pipes 129 to heat exchanger 135. Cooled liquid from heat exchanger 135 is passed to header tank 152, which regulates the pressure of the second cooling liquid.

Pump 134 drives the circulation of the second cooling liquid by drawing liquid from the header tank and pumping it to plenum chamber 148. The liquid is then distributed back to the cooling units via pipes 129. Pump 134 may be similar to pump 116 of Figure 8, but is desirably of a larger scale to pump liquid to several cooling units 130, 131, 132 instead of one. Arrows show the direction of liquid flow. Heat transfer device 135 has the same function as the heat transfer device 118 of Figure 8, except that it is desirably of a larger scale to transfer heat from several cooling units 130, 131, 132 instead of one.

The third stage of the system uses a third cooling liquid to transfer heat from the heat exchange device 135 to a final heat exchanger 137. Pump 136 is used to circulate the liquid. Atmospheric air or cool groundwater, used as the final heat sink medium, enters the heat exchanger at 138 and leaves at 139. In this case, and especially in systems that cool large arrays of servers, the entropy of the liquid carrying the heat may be low enough to be used for other purposes, rather than be dumped into the environment. It may be used as a source of energy for heating a building for human occupation or the generation of useful amounts of electrical power. In other circumstances, where an unusually high atmospheric temperature would otherwise reduce the temperature difference between the source and atmospheric final heat sink to too low a level, excess heat may be diverted (by diverting some of the final liquid) to refrigeration ("chiller") units, or additional energy or cost might be expended in the final heat exchanger (such as the use of adiabatic "dry coolers", which spray water into the air to reduce the effective ambient temperature, wet bulb temperature).

Figure 9 also shows signal outputs E1, E2, E3 from cooling units 130, 131 and 132. Further signal outputs (not shown) may be provided by additional cooling units so that the full set is E1,E2,E3.....En. Also shown are control inputs B and C to pump 134 and pump 135 respectively, and control input D to final heat exchanger 137. These can be used for monitoring and control purposes. This will be explained in more detail below.

Referring now to Figure 10, there is shown a monitoring and control system 140 for use with the three-stage cooling system of Figure 9. The system comprises: data inputs 146; and pump control outputs 145.

A monitoring and control system is used to monitor the temperatures of the electronic devices to be cooled and to adjust the flow rate of the second cooling liquid, third cooling liquid or both to provide optimum cooling. Sensors on each electrical circuit board measure the temperature of the electronic components and convert this information to analogue or digital signals. Figure 9 shows signal outputs E1, E2, E3, which can be extended to En, where n is the total number of cooling units that contain temperature-sensing devices, and where each signal contains information about the temperature of the one or more sealable modules in each cooling unit. These outputs are sent to the control system 140.

The control system 140 computes the optimum flow rate of second cooling liquid, the optimum flow rate of the third cooling liquid and the rate at which the final heat exchanger should operate and produces in response a control message B, C, D. Control messages B and C are used to turn on or off or vary the pumping rate of pumps 134 and 136 respectively. In addition, the control system determines whether or not the final heat exchanger needs to adjust its cooling rate, for example by altering the flow level of the final heat sink liquid or air, using control signal D.

The overall thermal capacity of the system is large, so that short term relatively large increases in ambient temperature (and thus the temperature of the final heat sink) can be accommodated without the key components exceeding their maximum temperature ratings. The ambient temperature on the hottest days may rise to a level where not all of the heat generated by the components to be cooled can be removed. The operating temperature of components may rise but the high thermal capacity means that the rise takes place slowly and maximum temperatures are not exceeded. During the cooler part of the diurnal cycle, more heat can be removed than is generated. In this way the system can be operated at locations with climates that would not otherwise allow refrigeration-free cooling. The control system can be optimised to use ambient temperature data, measured from external sensors and from historical trend data and statistics, to ensure that the flow rates are optimised. In the rare event that very exceptional temperatures occur, timely warning can be given to either reduce the effective temperature of the final heat sink (such as by switching to an active mode of cooling) or otherwise enable the system operator to take appropriate remedial actions.

In systems where "run-time hardware abstraction" of processing systems is used (such as with "virtualisation" or "run-time middleware"), the monitoring and control system is particularly important. In systems with hardware abstraction, the multiple electronic circuits boards ("hardware") and multiple computer operating systems are not in one to one correspondence. When one circuit board is under high processing load, some activity can be shared with other boards. Processing is distributed across the items of hardware. As a result, heat generated in different parts of the systems varies from time to time. Cooling rates in different parts of the system may then be adjusted dynamically to align with the changes in amounts of heat generated.

If the first cooling liquid in the sealable module 41 (and thus, the circuit board 75) is to operate at a desired temperature, T_{case}, and the final heat sink is at a known temperature Tₕₛ, this defines the temperature difference that the cooling system desirably provides, in that ΔT = T_{case} - Tₕₛ. Since T_{case} is desirably restricted to no higher than the maximum operating temperature of the circuit board, T_{case,max}, then ΔT ≤ T_{case,max} -Tₕₛ.

Semiconductor manufacturers are increasingly reducing the maximum operating temperature of their processors. This reduces the temperature difference, particularly when refrigeration is not employed to increase the local temperature difference. A further difficulty arises when the final heat sink is at atmospheric temperature, which may be as high as 40 degrees centigrade.

Reducing the thermal resistances in the system can assist to achieve the desired temperature difference. Systems which transfer heat through fluid flow may result in reduced thermal resistance compared with systems which transfer heat, either in full or in significant part, through static, thermally-coupled bodies or through gases. For example, the flow rate of the second cooling liquid can be adjusted to reduce the thermal resistance between the sealable module 41 and the heat exchanger 118. Additionally or alternatively, the area of contact between the second cooling liquid flowing through the channels 61 and the conduction surface 71 can be varied to affect the thermal resistance.

The use of tightly-packed channels 61 increases the pressure drop (i.e. hydraulic pressure losses) in the cold plate which increases the pumping costs for the secondary cooling liquid circuit. The width of the channel can be modified to reduce pressure losses and decrease the effect of the conduction surface 71 in the cold plate 22 in transferring heat into water channels.

At one extreme, the channels 61 could be as wide or wider than the dimensions of the housing 81 to present a "flood plain", rather than a "serpentine river", of second cooling liquid. However, controlling flow of second cooling liquid in such an embodiment may be difficult and features such as eddy currents may cause local build up of heat, which is undesirable as it will reduce rate of heat transfer for adjoining areas of conduction surface 71.

Therefore, the channel 61 width can be less than, but significant in comparison with a dimension of the housing 81. Optimisation of the cross-section of the channels 61 can improve the temperature difference. Channels 61 that are approximately 20% of the length of the longest channel 61 may be defined by baffles that direct flow over specific areas. Also, the flow of the second cooling liquid can be portioned with the channels 61 into sections such that the water is distributed into zones and slowed over areas with greatest heat flux (e.g. processors), the reintroduction of heat back into the primary coolant can be minimised, whilst the entropy of the extracted heat can be minimised.

Whilst a preferred embodiment and operating modes of the present invention have been described above, the skilled person will appreciate that various modifications can be made.

For example, cold plate 5 shown in Figure 1 is optional and the skilled person will appreciate that this need not be included. Instead of inserting cooling units 2 into the equipment rack 1 from the front, they could be inserted from the rear of the rack. Advantageously, the cooling units could be adapted to carry only one sealable module in each unit, so that units may then be inserted both at the front and rear of the rack. Electrical and liquid connections are then made in the middle of the rack. A single module unit is much lighter in weight than a two module unit and can be safely carried, fitted or removed by a single person.

Although intermediate stages of heat transfer and a final heat sink may use liquid cooling, other cooling mechanisms can alternatively be used, such as convection cooling.

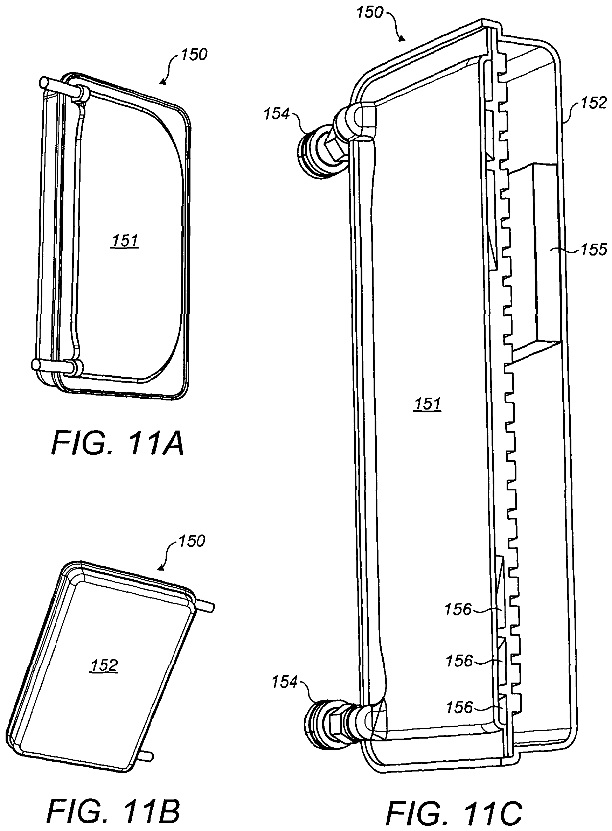

The skilled person will also recognise that the present invention can be implemented and operated in a number of different ways. Referring now to Figure 11A and Figure 11B, there are shown side views of a second embodiment of a sealable module 150 according to the present invention, which is an alternative to that described above. The sealable module 150 comprises an outer cover 151 and housing 152. Although the second embodiment differs slightly from the first embodiment, the skilled person will appreciate that many features of the two embodiments are interchangeable.

The channels in the cold plate 60 are closed by the outer cover 151. The assembly, which defines the channels, can be termed a "water jacket", because it dictates the flow of water (as second cooling liquid) for heat to flow over a heat transfer surface, such as a conduction surface 71.

Referring now to Figure 11C, there is shown a more detailed view of the sealable module according to Figure 11A and Figure 11B. The sealable module 150 also comprises a heat transfer surface 153, which together with the outer housing 151 defines channels 156. Also, the heat transfer surface 153 and lid 152 (which can be termed a base or housing) define an inner chamber with an internal volume for locating the electronic device 155 to be cooled and the first cooling liquid (not shown). Connectors 154 are also shown, for allowing flow of the second cooling liquid through channels 156.

This alternative embodiment of a module may therefore comprise an inner housing, containing the first cooling liquid and one or more motherboards, substantially sealed (except for a filling port). A heat transfer surface 153 has a gasketed interface with the inner housing and fins facing into the first cooling liquid, shaped to match the profile of the at least one motherboard. The outer housing 151 also has a gasketed interface with the heat transfer surface 153, and contains at least one secondary cooling liquid circuit channel 156, formed with baffles on the heat transfer surface 153 or on the interior surface of the outer housing 151. The at least one channel 156 is optimised to direct the second cooling liquid appropriately over the heat transfer surface 153 with minimised pressure loss. The outer housing 151 has quick-connect hydraulic connectors 154 to enable the channel 156 to be connected to the inlet and the outlet of a rack second cooling liquid supply.

This design allows much tighter integration between the inner housing, heat transfer surface 153 and outer housing 151 potentially to make a smaller unit, which may allow increased packing density of modules. Fins or baffles may be provided on both sides of heat transfer surface 153 . These can, for example, provide additional flow control of second cooling liquid and increase surface area for conduction.

The materials for the present invention can be varied. Metal materials are good conductors, but expensive. Also, if the heat transfer surface 153 or conduction surface 71 (which can be similar or identical) are made of metal and are large, they may be more likely to warp, putting stress on seals, especially if multiple sealable modules are mounted thereon, meaning areas of potentially different temperature.

In contrast, synthetic plastic materials are inferior conductors in comparison with metal. Known thermally conductive plastics typically conduct 20W/mK compared to 141W/mK for aluminium. Higher performance thermally conductive plastics are also usually electrically conductive, which is not a desirable characteristic. However, these materials are less expensive, of lighter weight and are less likely to corrode in the presence of hot water (notwithstanding the possible addition of corrosion inhibitors to the second cooling liquid) than metals.

Optimisation of the temperature difference by control of second cooling liquid flow rates, area of heat transfer and channel cross-section can allow the use of plastic without significant reduction in the temperature difference. In particular, plastic can be used for the base part 22 of the cold plate or the outer housing ("water jacket") described above. A plastic material reduces the amount of heat transferred through the outer wall of the base part 22 or outer housing 151 and into the local ambient environment, reducing heat lost in this way and increasing efficiency of heat removal into second cooling liquid.

Additionally or alternatively, the conduction surface 71 or heat transfer surface 153 can be made of plastic. This may provide additional expansion capacity for the first cooling liquid within the sealed housing. Such a material might be co-moulded with a rigid central thermal conductive plastic and peripheral ring of flexible non-conductive plastic.

A number of features of the embodiment described above will be understood as optional to the skilled person and might be omitted. These may include insulation 73, which could additionally be made of a fire retardant material and quick release connectors 111. Also, the skilled person will understand that alternative constructions for the cold plate 60 or outer housing 151 can be used and that the projections 96, 97 can be of different length and cross-section to that described.

Although an embodiment described above uses a cooling unit 2 in which one sealable module 41 is affixed to a cold plate 60, it will be recognised that two or more sealable modules 41 might be coupled to a common cold plate. Also, cooling units 2 may be inserted from both back and front of the rack.

The electronic circuit board can be combined with housing 81 to form an integrated assembly. This provides a means of connection to electronic components directly from the circuit board, thus reducing the risk of liquid leaking from cable seals in the module, reducing the overall width of a sealable module and increasing packing density of cooling units within a rack.

The data transmission cables 46 can be replaced by fibre optic cables, optical or infra-red ports or wireless connection between the electronic circuit board and the exterior of the sealable module. Power supply connections would normally be wired, even when the data transmission is by other means, although alternative power supplies may be employed, whilst avoiding fluid leakage.

The second cooling liquid may be distributed via pipes with individual flow control valves, rather than a plenum chamber. The valves may be locally adjusted or controlled automatically by a central monitoring and control system similar to control system 140 shown in Figure 10 in response to temperature and status information from the components housed within the sealable modules 41. Also, in the system of Figure 8, heat exchanger 121 can alternatively be replaced by cool groundwater or a number of configurations including bypass circuits to transfer some heat to refrigeration systems. To provide resilience and redundancy additional "back-up" pumps and circuits may optionally be provided.

When the final heat sink 121 is close to the equipment to be cooled and the pressure of the cooling liquid circulating in this stage can be lower, a second stage of cooling might be omitted. In this case, the second cooling liquid circulates directly through the final heat exchanger. Pump 116 and intermediate heat transfer device 118 or 135 are omitted. As with the embodiment illustrated in Figure 8, the three-stage system shown in Figure 9 could be reduced to two stages if the liquid pressure in the final stage were low enough.

## Claims

1. A cooled electronic system, comprising:
a first sealable container (41) comprising: a housing (81) at least partially defining an internal volume; an electronic device (68, 69) within the internal volume and immersed in a primary cooling liquid;
a heat transfer device (60) defining a first channel (61) for receiving a secondary cooling liquid, the first heat transfer device being configured to transfer heat between the primary cooling liquid and the secondary cooling liquid in the first channel through at least a portion of a conduction surface (71), at least a part of the electronic device being spatially separated from the conduction surface by the primary cooling liquid so as to allow heat transfer from the electronic device through the primary cooling liquid to the conduction surface, the heat transfer device forming part of the internal volume; and
a piping arrangement (112), configured to transfer the secondary cooling liquid to and from the heat transfer device;
wherein the cooled electronic system is configured to set a flow rate of the secondary cooling liquid through the first channel so as to control the temperature of the electronic device not to exceed a predetermined maximum operating temperature;
the cooled electronic system further comprising:
a second sealable container (41) comprising: a second housing; a second electronic device immersed in a second primary cooling liquid for receiving heat from the second electronic device; and
a second heat transfer device for receiving a second secondary cooling liquid and being configured to transfer heat between the second primary cooling liquid and the second secondary cooling liquid; and
wherein the piping arrangement comprises: a liquid flow splitter (55) configured having a common input for receiving cooling liquid and configured to split the received cooling liquid and output the first secondary cooling liquid to the first heat transfer device and the second secondary cooling liquid to the second heat transfer device, each of the first and second sealable containers being connected to the liquid flow splitter (55) via a respective inlet pipe (53) for the respective secondary cooling liquid and a first further pipe (58) connecting the common input to a liquid input connector (12); and a flow-combining unit (57) configured to receive the first secondary cooling liquid from the first heat transfer device and the second secondary cooling liquid from the second heat transfer device, combine the received first secondary cooling liquid and second secondary cooling liquid and provide a common output, a respective liquid outlet pipe (54) carrying respective secondary cooling liquid from each of the first and second sealable modules to the flow-combining unit (57) and a second further pipe (59) connecting the common output to a liquid output connector (11).

2. The cooled electronic system of claim 1, further comprising:
a pump (116), configured to cause the secondary cooling liquid to flow and to adjust the flow rate of the secondary cooling liquid.

3. The cooled electronic system of claim 1 or claim 2, wherein the piping arrangement comprises a plenum chamber (147), arranged to collect the combined first and second secondary cooling liquids.

4. The cooled electronic system of claim 3, wherein the piping arrangement comprises:
a first plenum chamber (147), arranged to collect the combined first and second secondary cooling liquids from the first and second heat transfer devices respectively;
a second heat transfer device (135), for receiving the combined first and second secondary cooling liquids from the first plenum chamber and transferring heat between the combined first and second secondary cooling liquids and a heat sink; and
a second plenum chamber (148), for receiving the combined first and second secondary cooling liquids from the second heat transfer device, providing the first secondary cooling liquid to the first heat transfer device and providing the second secondary cooling liquid to the second heat transfer device.

5. The cooled electronic system of any preceding claim, further configured to set a flow rate of the combined first and second secondary cooling liquid so as to control the temperatures of the first and second electronic devices not to exceed predetermined first and second maximum operating temperatures respectively.

6. The cooled electronic system of any preceding claim, wherein the secondary cooling liquid comprises water.

7. The cooled electronic system of any preceding claim, wherein the electronic device comprises one or more computer motherboards .

## Patentansprüche

1. Gekühltes elektronisches System, umfassend:
einen ersten verschließbaren Behälter (41), der umfasst: ein Gehäuse (81), das zumindest teilweise ein Innenvolumen begrenzt; eine elektronische Vorrichtung (68, 69) in dem Innenvolumen und eingetaucht in eine primäre Kühlflüssigkeit;
eine Wärmeübertragungsvorrichtung (60), die einen ersten Kanal (61) zur Aufnahme einer sekundären Kühlflüssigkeit begrenzt, wobei die erste Wärmeübertragungsvorrichtung ausgestaltet ist, Wärme zwischen der primären Kühlflüssigkeit und der sekundären Kühlflüssigkeit in dem ersten Kanal durch zumindest einen Abschnitt einer leitenden Oberfläche (71) zu übertragen, wobei zumindest ein Teil der elektronischen Vorrichtung durch die primäre Kühlflüssigkeit räumlich von der leitenden Oberfläche getrennt ist, so dass eine Wärmeübertragung von der elektronischen Vorrichtung durch die primäre Kühlflüssigkeit zu der leitenden Oberfläche ermöglicht wird, wobei die Wärmeübertragungsvorrichtung Teil des Innenvolumens bildet; und
eine Rohrleitungsanordnung (112), die zum Weiterleiten der sekundären Kühlflüssigkeit zur Wärmeübertragungsvorrichtung hin und von dieser weg konfiguriert ist;
wobei das gekühlte elektronische System zum Festlegen einer Durchflussmenge der sekundären Kühlflüssigkeit durch den ersten Kanal konfiguriert ist, um die Temperatur der elektronischen Vorrichtung so zu steuern, dass diese eine vorher festgelegte maximale Betriebstemperatur nicht überschreitet;
wobei das gekühlte elektronische System weiter umfasst:
einen zweiten verschließbaren Behälter (41), der umfasst: ein zweites Gehäuse; eine zweite elektronische Vorrichtung, die in eine zweite primäre Kühlflüssigkeit zur Aufnahme von Wärme von der zweiten elektronischen Vorrichtung eingetaucht ist; und
eine zweite Wärmeübertragungsvorrichtung zur Aufnahme einer zweiten sekundären Kühlflüssigkeit und ausgestaltet zum Übertragen von Wärme zwischen der zweiten primären Kühlflüssigkeit und der zweiten sekundären Kühlflüssigkeit; und
wobei die Rohrleitungsanordnung umfasst: einen Flüssigkeitsstrom-Teiler (55), der mit einem herkömmlichen Eingang zur Aufnahme von Kühlflüssigkeit ausgestaltet ist, und konfiguriert ist, die aufgenommene Kühlflüssigkeit zu teilen und die erste sekundäre Kühlflüssigkeit an die erste Wärmeübertragungsvorrichtung auszugeben und die zweite sekundäre Kühlflüssigkeit an die zweite Wärmeübertragungsvorrichtung auszugeben, wobei beide erster und zweiter verschließbarer Behälter mit dem Flüssigkeitsstrom-Teiler (55) über ein jeweiliges Einlassrohr (53) für die jeweilige sekundäre Kühlflüssigkeit verbunden sind, und ein weiteres Rohr (58) den gemeinsamen Eingang mit einem Flüssigkeitseingangs-Verbinder (12) verbindet; und eine Fluss-Kombiniereinheit (57), die zur Aufnahme der ersten sekundären Kühlflüssigkeit von der ersten Wärmeübertragungsvorrichtung und der zweiten sekundären Kühlflüssigkeit von der zweiten Wärmeübertragungsvorrichtung konfiguriert ist, die aufgenommene erste sekundäre Kühlflüssigkeit und zweite sekundäre Kühlflüssigkeit verbindet und einen gemeinsamen Ausgang bereitstellt, wobei ein jeweiliges Flüssigkeits-Auslassrohr (54) die jeweilige sekundäre Kühlflüssigkeit von jedem des ersten und zweiten verschließbaren Moduls zu der Fluss-Kombiniereinheit (57) führt und ein zweites weiteres Rohr (59) den gemeinsamen Ausgang mit einem Flüssigkeitsausgangs-Verbinder (11) verbindet.

2. Gekühltes elektronisches System nach Anspruch 1, das weiter umfasst:
eine Pumpe (116), die ausgestaltet ist, den Fluss der zweiten Kühlflüssigkeit zu bewirken und die Durchflussmenge der sekundären Kühlflüssigkeit anzupassen.

3. Gekühltes elektronisches System nach Anspruch 1 oder Anspruch 2, wobei die Rohrleitungsanordnung eine Sammelkammer (147) umfasst, die zur Aufnahme der kombinierten ersten und zweiten sekundären Kühlflüssigkeiten angeordnet ist.

4. Gekühltes elektronisches System nach Anspruch 3, wobei die Rohrleitungsanordnung umfasst:
eine erste Sammelkammer (147), die zur Aufnahme der kombinierten ersten und zweiten sekundären Kühlflüssigkeiten von der ersten bzw. zweiten Wärmeübertragungsvorrichtung angeordnet ist;
eine zweite Wärmeübertragungsvorrichtung (135) zur Aufnahme der kombinierten ersten und zweiten sekundären Kühlflüssigkeiten von der ersten Sammelkammer und zur Übertragung von Wärme zwischen den kombinierten ersten und zweiten sekundären Kühlflüssigkeiten und einem Kühlkörper; und
eine zweite Sammelkammer (148) zur Aufnahme der kombinierten ersten und zweiten sekundären Kühlflüssigkeiten von der zweiten Wärmeübertragungsvorrichtung, wobei die erste sekundäre Kühlflüssigkeit an die erste Wärmeübertragungsvorrichtung geliefert wird und die zweite sekundäre Kühlflüssigkeit an die zweite Wärmeübertragungsvorrichtung geliefert wird.

5. Gekühltes elektronisches System nach einem der vorhergehenden Ansprüche, das weiter ausgestaltet ist, eine Durchflussmenge der kombinierten ersten und zweiten sekundären Kühlflüssigkeit festzulegen, um die Temperaturen der ersten und zweiten elektronischen Vorrichtung so zu steuern, dass diese eine vorher festgelegte erste bzw. zweite maximale Betriebstemperatur nicht überschreiten.

6. Gekühltes elektronisches System nach einem der vorhergehenden Ansprüche, wobei die sekundäre Kühlflüssigkeit Wasser umfasst.

7. Gekühltes elektronisches System nach einem der vorhergehenden Ansprüche, wobei die elektronische Vorrichtung ein oder mehrere Computer-Motherboards umfasst.

## Revendications

1. Système électronique refroidi, comprenant :
un premier récipient scellable (41), comprenant : un boîtier (81) définissant au moins partiellement un volume interne ; un dispositif électronique (68, 69) à l'intérieur du volume interne et immergé dans un liquide de refroidissement primaire ;
un dispositif de transfert de chaleur (60) définissant un premier canal (61) pour recevoir un liquide de refroidissement secondaire, le premier dispositif de transfert de chaleur étant configuré pour transférer de la chaleur entre le liquide de refroidissement primaire et le liquide de refroidissement secondaire dans le premier canal à travers au moins une partie d'une surface de conduction (71), au moins une partie du dispositif électronique étant séparée spatialement de la surface de conduction par le liquide de refroidissement primaire de manière à permettre un transfert de chaleur depuis le dispositif électronique, à travers le liquide de refroidissement primaire vers la surface de conduction, le dispositif de transfert de chaleur faisant partie du volume interne ; et
un agencement de canalisation (112), configuré pour transférer le liquide de refroidissement secondaire vers et depuis le dispositif de transfert de chaleur ;
dans lequel le système électronique refroidi est configuré pour définir un débit d'écoulement du liquide de refroidissement secondaire à travers le premier canal de manière à commander la température du dispositif électronique pour qu'elle ne dépasse pas une température de fonctionnement maximale prédéterminée ;
le système électronique refroidi comprenant en outre :
un second récipient scellable (41) comprenant : un second boîtier ; un second dispositif électronique immergé dans un second liquide de refroidissement primaire pour recevoir de la chaleur provenant du second dispositif électronique ; et
un second dispositif de transfert de chaleur pour recevoir un second liquide de refroidissement secondaire et étant configuré pour transférer de la chaleur entre le second liquide de refroidissement primaire et le second liquide de refroidissement secondaire ; et
dans lequel l'agencement de canalisation comprend : un séparateur de flux de liquide (55) configuré en ayant une entrée commune pour recevoir un liquide de refroidissement et configuré pour séparer le liquide de refroidissement reçu et délivrer en sortie le premier liquide de refroidissement secondaire vers le premier dispositif de transfert de chaleur et le second liquide de refroidissement secondaire vers le second dispositif de transfert de chaleur, chacun des premier et second récipients scellables étant relié au séparateur de flux de liquide (55) par l'intermédiaire d'un tuyau d'entrée respectif (53) pour le liquide de refroidissement secondaire respectif et un premier tuyau supplémentaire (58) reliant l'entrée commune à un connecteur d'entrée de liquide (12); et une unité de combinaison de flux (57) configurée pour recevoir le premier liquide de refroidissement secondaire depuis le premier dispositif de transfert de chaleur et le second liquide de refroidissement secondaire depuis le second dispositif de transfert de chaleur, pour combiner le premier liquide de refroidissement secondaire et le second liquide de refroidissement secondaire reçus et fournir une sortie commune, un tuyau de sortie de liquide respectif (54) transportant le liquide de refroidissement secondaire respectif depuis chacun des premier et second modules scellables vers l'unité de combinaison de flux (57) et un second tuyau (59) reliant la sortie commune à un connecteur de sortie de liquide (11).

2. Système électronique refroidi selon la revendication 1, comprenant en outre :
une pompe (116), configurée pour amener le liquide de refroidissement secondaire à s'écouler et pour ajuster le débit d'écoulement du liquide de refroidissement secondaire.

3. Système électronique refroidi selon la revendication 1 ou la revendication 2, dans lequel l'agencement de canalisation comprend une chambre de distribution (147), agencée pour collecter les premier et second liquides de refroidissement secondaires combinés.

4. Système électronique refroidi selon la revendication 3, dans lequel l'ensemble de canalisation comprend :
une première chambre de distribution (147), agencée pour collecter les premier et second liquides de refroidissement secondaires combinés à partir des premier et second dispositifs de transfert de chaleur, respectivement ;
un second dispositif de transfert de chaleur (135), pour recevoir les premier et second liquides de refroidissement secondaires combinés à partir de la première chambre de distribution et transférer de la chaleur entre les premier et second liquides de refroidissement secondaires combinés et un dissipateur thermique ; et
une seconde chambre de distribution (148), pour recevoir les premier et second liquides de refroidissement secondaires combinés provenant du second dispositif de transfert de chaleur, pour fournir le premier liquide de refroidissement secondaire au premier dispositif de transfert de chaleur et pour fournir le second liquide de refroidissement secondaire au second dispositif de transfert de chaleur.

5. Système électronique refroidi selon l'une quelconque des revendications précédentes, configuré en outre pour régler un débit d'écoulement du premier et du second liquide de refroidissement secondaire combinés de manière à commander les températures des premier et second dispositifs électroniques pour qu'elles ne dépassent pas respectivement des première et seconde températures de fonctionnement maximales prédéterminées.

6. Système électronique refroidi selon l'une quelconque des revendications précédentes, dans lequel le liquide de refroidissement secondaire comprend de l'eau.

7. Système électronique refroidi selon l'une quelconque des revendications précédentes, dans lequel le dispositif électronique comprend une ou plusieurs cartes mères d'ordinateur.
